# EUROPÄISCHE PATENTSCHRIFT

(11) **EP 2 976 440 B1**
(45) Veröffentlichungstag und Bekanntmachung des Hinweises auf die Patenterteilung: **09.01.2019**
(21) Anmeldenummer: 14721805.1
(22) Anmeldetag: 22.04.2014
(51) Int. Cl.: C22C 19/05, C23C 4/08, C23C 14/06, C22C 30/00, C23C 28/00, F01D 5/28

(54) **SCHUTZBESCHICHTUNG UND GASTURBINENKOMPONENTE MIT DER SCHUTZBESCHICHTUNG**
PROTECTIVE COATING AND GAS TURBINE COMPONENT HAVING SAID PROTECTIVE COATING
REVÊTEMENT PROTECTEUR ET ÉLÉMENT DE TURBINE À GAZ POURVU DE CE REVÊTEMENT PROTECTEUR

(30) Priorität: 17.05.2013 DE 102013209189
(43) Veröffentlichungstag der Anmeldung: 27.01.2016
(73) Patentinhaber: Siemens Aktiengesellschaft, 80333 München (DE)
(72) Erfinder: LI, Xin-Hai, S-58272 Linköping (SE)
(86) Internationale Anmeldenummer: PCT/EP2014/058129
(87) Internationale Veröffentlichungsnummer: WO 2014/183962

(56) Entgegenhaltungen:
- WO-A1-2013/037391
- US-A1- 2004 131 865
- US-A1- 2011 256 417

## Beschreibung

Die Erfindung betrifft eine Schutzbeschichtung für eine Gasturbinenkomponente.

Eine Strömungsmaschine, insbesondere eine Gasturbine, weist eine Turbine auf, in der Heißgas, das zuvor in einem Verdichter verdichtet und einer Brennkammer erhitzt wurde, zur Arbeitsgewinnung entspannt wird. Der thermodynamische Wirkungsgrad der Gasturbine ist umso höher, je höher die Eintrittstemperatur des Heißgases in die Turbine ist. Demgegenüber sind Grenzen gesetzt hinsichtlich der thermischen Belastbarkeit der Komponenten der Gasturbine, insbesondere der Leitschaufeln, der Laufschaufeln und des Gehäuses.

Somit ist es erstrebenswert Gasturbinenkomponenten zu schaffen, die trotz einer möglichst hohen thermischen Belastung eine für den Betrieb der Gasturbine ausreichende chemische Beständigkeit haben. Es ist bekannt auf die Gasturbinenkomponenten eine Schutzbeschichtung aufzubringen, um die darunter liegenden Gasturbinenkomponenten vor Oxidation und Korrosion zu schützen. Herkömmlich ist die Schutzbeschichtung aus einer MCrAlX-Legierung hergestellt, wobei M für Nickel (Ni) und/oder Kobalt (Co) und X beispielsweise für Yttrium (Y), Rhenium (Re), Gadolinium (Gd), Lanthan (La), Platin (Pt) und/oder ein Seltenerdenmetall steht. Beim Aufbringen der Schutzbeschichtung auf die Gasturbinenkomponente wird das Aluminium der Schutzbeschichtung oxidiert und das dabei entstehende Aluminiumoxid hat eine gute Anbindung an die Gasturbinenkomponente und schützt sie vor Oxidation und Korrosion.

Bei den vorher genannten Elementen für X handelt es sich um Elemente, die in den vergangen Jahren einem dramatischen Preisanstieg unterlegen sind, so dass die herkömmlichen Schutzbeschichtungen kostenintensiv sind. Zudem führen Einschlüsse von Yttriumoxid in der Aluminiumoxidschicht zu einer hohen Diffusionsgeschwindigkeit des Sauerstoffs, was in einer schnelleren Oxidation der Schutzbeschichtung resultiert. Die Oxidation der Schutzbeschichtung führt dazu, dass die darunter liegende Gasturbinenkomponente nicht mehr geschützt wird, so dass ihre Lebensdauer verkürzt wird.
Die US 2004/0131865 A1 offenbart eine 32.6Ni-32.7Co-20.1Cr-7.81Al-0.39Y-5.34Fe-Legierung.
Aufgabe der Erfindung ist es eine Schutzbeschichtung und eine Gasturbinenkomponente mit der Schutzbeschichtung herzustellen, wobei die Schutzbeschichtung kostengünstig ist und die Gasturbinenkomponente eine lange Lebensdauer hat.
Die Aufgabe wird gelöst mit den Merkmalen der Patentansprüche 1 und 3. Bevorzugte Ausgestaltungen dazu sind in den weiteren Patentansprüchen angegeben.

Die Schutzbeschichtung stellt einen wirksamen Schutz vor Oxidation und Korrosion dar. Zudem ist die Schutzbeschichtung wegen dem geringen Anteil an wertvollen Elementen kostengünstig. Durch den Anteil an Eisen in der Schutzbeschichtung erfolgt zudem eine Stabilisierung von aluminiumreichen Phasen. Beim Aufbringen der Schutzbeschichtung oder wenn die Schutzbeschichtung heißen Gasen ausgesetzt ist, kann das Aluminiumoxid in der Schutzbeschichtung oxidiert werden und es bildet sich auf der Oberfläche der Schutzbeschichtung eine Aluminiumoxidschicht aus. Weil der Gehalt an Yttrium in der Schutzbeschichtung gering ist, werden in der Aluminiumoxidschicht nur wenige Einschlüsse von Yttriumoxid gebildet. Dadurch kann nur wenig Sauerstoff in die Schutzbeschichtung transportiert werden, wodurch die Lebensdauer der Schutzbeschichtung lang ist.

Bevorzugtermaßen weist die Schutzbeschichtung 0 bis 4 Gew.-% Silizium (Si) auf. Die Schutzbeschichtung weist bevorzugt 0 bis 2 Gew.-% Tantal (Ta) auf. Weiterhin ist bevorzugt, dass die Schutzbeschichtung 0 bis 2 Gew.-% Hafnium (Hf) aufweist.
Der Anteil an Schwefel (S) in der Schutzbeschichtung ist bevorzugt kleiner gleich 8*10⁻⁶ Gew.-%. Dadurch wird vorteilhaft die Lebensdauer der Schutzbeschichtung weiter erhöht.

Weiterhin betrifft die Erfindung die Verwendung einer vorstehend beschriebenen Schutzbeschichtung für eine Gasturbinenkomponente, insbesondere einer Turbinenschaufel oder einer Brennkammerkomponente.

Die erfindungsgemäße Gasturbinenkomponente weist die Schutzbeschichtung auf. Die Gasturbinenkomponente weist bevorzugt ein Substrat auf, auf das die Schutzbeschichtung aufgebracht ist, wobei das Substrat aus einer nickelbasierten Superlegierung und/oder einer kobaltbasierte Superlegierung ist. Die Gasturbinenkomponente hat durch das Vorsehen der Schutzbeschichtung eine lange Lebensdauer im Betrieb der Gasturbine. Die Schutzbeschichtung hat bevorzugt eine Dicke von 30 µm bis 800 µm.

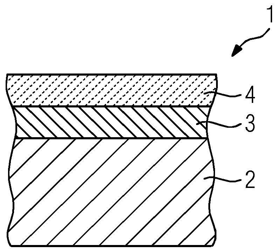

Die Schutzbeschichtung ist bevorzugt mittels eines thermischen Spritzverfahrens, insbesondere in Luft, in Vakuum oder unter einem Schutzgas, und/oder mittels eines physikalischen Abscheideverfahrens (englisch: "physical vapour deposition", PVD) auf das Substrat aufgebracht.
Im Folgenden wird eine bevorzugte Ausführungsform der erfindungsgemäßen Gasturbinenkomponente anhand der beigefügten schematischen Zeichnung erläutert. Die Figur zeigt einen Schnitt durch die Ausführungsform.
Wie es aus Figur 1 ersichtlich ist, weist eine Gasturbinenkomponente 1 ein Substrat 2, eine Schutzbeschichtung 3 und eine Keramikschicht 4 auf. Das Substrat 2 ist beispielsweise eine Leitschaufel oder eine Laufschaufel in der Turbine einer Gasturbine. Das Substrat 2 ist dabei aus einer nickelbasierten Superlegierung oder aus einer kobaltbasierten Superlegierung gefertigt.
Unmittelbar auf das Substrat 2 ist die Schutzbeschichtung 3 mit einer Dicke von 30 µm bis 800 µm aufgebracht. Die Schutzbeschichtung 3 ist dabei mittels eines thermischen Spritzverfahrens oder eines physikalischen Abscheideverfahrens auf das Substrat 2 mit einer Zusammensetzung von 15 bis 39 Gew.-% Co, 10 bis 25 Gew.-% Cr, 5 bis 15 Gew.-% Al, 0,05 bis 1 Gew.-% Y, 0,5 bis 10 Gew.-% Fe, 0,05 bis 2 Gew.-% Mo, 0 bis 4 Gew.-% Si, 0 bis 2 Gew.-% Ta, 0 bis 2 Gew.-% Hf und als Rest Ni und Verunreinigungen aufgebracht. Bei den Verunreinigungen liegt der Anteil an S kleiner gleich 8*10⁻⁶ Gew.-%.
Durch Oxidation des Aluminiums entsteht auf der dem Substrat 2 abgewandten Oberfläche der Schutzbeschichtung 3 eine das Substrat 2 vor Oxidation und Korrosion schützende Aluminiumoxidschicht. Unmittelbar auf der Schutzbeschichtung 3 ist eine Keramikschicht 4 angeordnet, welche beispielsweise Zirkoniumoxid oder mit Yttriumoxid stabilisiertes Zirkoniumoxid aufweist.

Anhand von mehreren Beispielen wird im Folgenden die Erfindung näher erläutert.
Eine erste beispielhafte Schutzbeschichtung 3 weist 20 Gew.-% Co, 20 Gew.-% Cr, 10 Gew.-% Al, 0,1 Gew.-% Y, 5 Gew.-% Fe und 44,9 Gew.-% Ni sowie kleinere Mengen Verunreinigungen auf Dieses Beispeil ist nicht Gegenstand der Erfindung.

Eine zweite beispielhafte Schutzbeschichtung 3 weist 30 Gew.-% Co, 15 Gew.-% Cr, 15 Gew.-% Al, 0,3 Gew.-% Y, 8 Gew.-% Fe, 1 Gew.-% Mo und 30,7 Gew.-% Ni sowie kleinere Mengen Verunreinigungen auf.

Eine dritte beispielhafte Schutzbeschichtung 3 weist 12 Gew.-% Co, 12 Gew.-% Cr, 15 Gew.-% Al, 0,5 Gew.-% Y, 10 Gew.-% Fe, 1 Gew.-% Mo, 3 Gew.-% Si, 0,5 Gew.-% Ta, 0,5 Gew.-% Hf und 45,5 Gew.-% Ni sowie kleinere Mengen Verunreinigungen auf.

In drei beispielhaften Gasturbinenkomponenten sind die drei beispielhaften Schutzbeschichtungen jeweils mit einem thermischen Spritzverfahren auf ein Substrat aus einer nickelbasierten Superlegierung aufgebracht.

## Patentansprüche

1. Schutzbeschichtung auf einem Substrat (2) aufweisend 15 bis 39 Gew.-% Co, 10 bis 25 Gew.-% Cr, 5 bis 15 Gew.-% Al, 0,05 bis 1 Gew.-% Y, 0,5 bis 10 Gew.-% Fe, 0,05 bis 2 Gew.-% Mo,
optional
0 bis 4 Gew.-% Si, 0 bis 2 Gew.-% Ta und/oder 0 bis 2 Gew.-% Hf,
Rest Ni und Verunreinigungen.

2. Schutzbeschichtung gemäß Anspruch 1,
wobei der Anteil an Schwefel in der Schutzbeschichtung (3) kleiner gleich 8*10⁻⁶ Gew.-% ist.

3. Gasturbinenkomponente mit der Schutzbeschichtung (3) gemäß einem der Ansprüche 1 oder 2.

4. Gasturbinenkomponente gemäß Anspruch 3,
wobei die Gasturbinenkomponente ein Substrat (2) aufweist, auf das die Schutzbeschichtung (3) aufgebracht ist, wobei das Substrat (2) aus einer nickelbasierten Superlegierung und/oder einer kobaltbasierte Superlegierung ist.

5. Gasturbinenkomponente gemäß Anspruch 3 oder 4,
wobei die Schutzbeschichtung (3) eine Dicke von 30 µm bis 800 µm hat.

6. Gasturbinenkomponente gemäß Anspruch 4 oder 5,
wobei die Schutzbeschichtung (3) mittels eines thermischen Spritzverfahrens, insbesondere in Luft, in Vakuum oder unter einem Schutzgas, und/oder mittels eines physikalischen Abscheideverfahrens auf das Substrat (2) aufgebracht ist.

## Claims

1. Protective coating on a substrate (2) having 15 to 39 wt% Co, 10 to 25 wt% Cr, 5 to 15 wt% Al, 0.05 to 1 wt% Y, 0.5 to 10 wt% Fe, 0.05 to 2 wt% Mo,
optionally
0 to 4 wt% Si, 0 to 2 wt% Ta, and/or 0 to 2 wt% Hf,
remainder Ni and impurities.

2. Protective coating according to Claim 1, wherein the fraction of sulfur in the protective coating (3) is less than or equal to 8*10⁻⁶ wt%.

3. Gas turbine component having the protective coating (3) according to either of Claims 1 and 2.

4. Gas turbine component according to Claim 3,
wherein the gas turbine component has a substrate (2) onto which the protective coating (3) is applied, wherein the substrate (2) is made of a nickel-based superalloy and/or a cobalt-based superalloy.

5. Gas turbine component according to Claim 3 or 4,
wherein the protective coating (3) has a thickness of 30 µm to 800 µm.

6. Gas turbine component according to Claim 4 or 5, wherein the protective coating (3) is applied to the substrate (2) by means of a thermal spraying method, in particular in air, in vacuo or under a protective gas, and/or by means of a physical deposition method.

## Revendications

1. Revêtement de protection sur un substrat (2), comportant de 15 à 39% en poids de Co, de 10 à 25% en poids de Cr, de 5 à 15% en poids d'Al, de 0,05 à 1% en poids de Y, de 0,5 à 10% en poids de Fe, de 0,05 à 2% en poids de Mo,
facultativement
de 0 à 4% en poids de Si, de 0 à 2% en poids de Ta et/ou de 0 à 2% en poids de Hf,
le reste étant du Ni et des impuretés.

2. Revêtement de protection suivant la revendication 1,
dans lequel la proportion de soufre dans le revêtement (3) de protection est inférieure ou égale à 8*10⁻⁶% en poids.

3. Elément de turbine à gaz ayant le revêtement (3) de protection suivant l'une des revendications 1 ou 2.

4. Elément de turbine à gaz suivant la revendication 3,
dans lequel l'élément de turbine gaz a un substrat (2), sur lequel le revêtement (3) de protection est déposé, le substrat (2) étant en un superalliage à base de nickel et/ou en un superalliage à base de cobalt.

5. Elément de turbine à gaz suivant la revendication 3 ou 4, dans lequel le revêtement (3) de protection a une épaisseur de 30 µm à 800 µm.

6. Elément de turbine à gaz suivant la revendication 4 ou 5, dans lequel le revêtement (3) de protection est déposé sur le substrat (2) au moyen d'un procédé par pulvérisation thermique, notamment dans de l'air, sous vide ou sous un gaz protecteur, et/ou au moyen d'un procédé de dépôt physique.
